**Europäisches Patentamt**

**European Patent Office**

**Office européen des brevets**

(19)

(11) Publication number: **0 015 111**
**B1**

(12) # EUROPEAN PATENT SPECIFICATION

(45) Date of publication of patent specification: **15.12.82**

(51) Int. Cl.³: **H 01 L 23/48, H 01 L 23/04**

(21) Application number: **80300398.7**

(22) Date of filing: **12.02.80**

(54) Lead frame and housing for integrated circuit.

(30) Priority: **23.02.79 US 14397**

(43) Date of publication of application:
**03.09.80 Bulletin 80/18**

(45) Publication of the grant of the patent:
**15.12.82 Bulletin 82/50**

(84) Designated Contracting States:
**AT BE CH DE FR GB IT NL SE**

(56) References cited:
**FR - A - 2 360 174**
**US - A - 3 716 761**
**US - A - 4 012 766**

**IEEE TRANSACTIONS ON COMPONENTS,
HYBRIDS, AND MANUFACTURING
TECHNOLOGY, vol. CHMT-1, no. 4, december
1978, New York US W.R. RODRIQUES DE
MIRANDA et al.: "Lead forming and outer
lead bond pattern design for tape-bonded
hybrids", pages 377—383.**

(73) Proprietor: **AMP INCORPORATED
Eisenhower Boulevard
Harrisburg, Pennsylvania (US)**

(72) Inventor: **Grabbe, Dimitry G.
301 Main Street
Lisbon Falls Maine (US)**
Inventor: **Patterson, Ronald
78A Stoney Creek Drive
Dauphin Pennsylvania (US)**

(74) Representative: **Wayte, Dennis Travers et al,
20 Queensmere
Slough, Berkshire SL1 1YZ (GB)**

Courier Press, Leamington Spa, England.

Lead frame and housing for integrated circuit

This invention relates to lead frames, and lead frames having housings moulded thereon for use in packaging integrated circuit elements.

Integrated circuit elements are being produced in large numbers in the form of flat chips which are usually square and which have terminal areas located on one surface thereof, usually along edges of the chip. These chips are being produced in several sizes and having different numbers of terminal areas. When a chip is packaged in a carrier, it is necessary to establish electrical connections to the terminal areas on the chip, and to provide conductors extending from the chip to the edge of the carrier so that the chip can be connected to further circuitry.

In accordance with conventional packaging techniques, it is normally necessary to provide a particular lead frame for each chip size and terminal area requirement, and clearly this is a burdensome inconvenience to the integrated circuit element packaging industry. Clearly, substantial economies could be achieved if a single standard lead frame and chip carrier could be used with chips in a range of sizes and chips having a range of numbers of terminal areas thereon.

According to this invention a lead frame capable of use with integrated circuit chips of different sizes and having different numbers of terminal areas, is characterised in that the lead frame comprises a centrally located support member, and a plurality of leads having inner end portions which are integral with the support member and having outer portions forming a radiating pattern relative to the support member, at least one of the leads being a composite lead comprising a trunk lead and branch leads extending from side edges of the trunk lead at spaced intervals and at increasing distances from the support member, whereby the lead frame can be used with a relatively small chip by removing the support member and connecting the leads, excluding the trunk lead, to the terminal areas of the chip, and the lead frame can be used with larger sizes of chips by removing the support member and a portion of the trunk lead adjacent to the support member whereby branch and other leads can be connected to terminal areas of the chip.

This invention will now be described by way of example with reference to the drawings, in which:—

Figure 1 is a perspective view of a section of a strip of integrated circuit element packages;

Figure 2 is a plan view of a lead frame in accordance with the invention;

Figures 3 to 5 are views similar to Figure 2, illustrating the manner in which chips of different sizes and requiring different numbers of leads can be accommodated by the lead frame of Figure 2;

Figure 6 is a plan view looking in the direction of the arrows VI in Figure 7, of a chip carrier housing moulded on to a lead frame;

Figure 7 is a view taken along the line VII—VII in Figure 6;

Figure 8 is a view taken along the line VIII—VIII in Figure 7;

Figure 9 is a plan view in the direction of the arrows IX—IX in Figure 7, but with a chip mounted in the housing; and

Figure 10 is a view taken along line X—X in Figure 9.

Figure 11 is a similar view as in Figure 10 with the leads being severed from the metal strip.

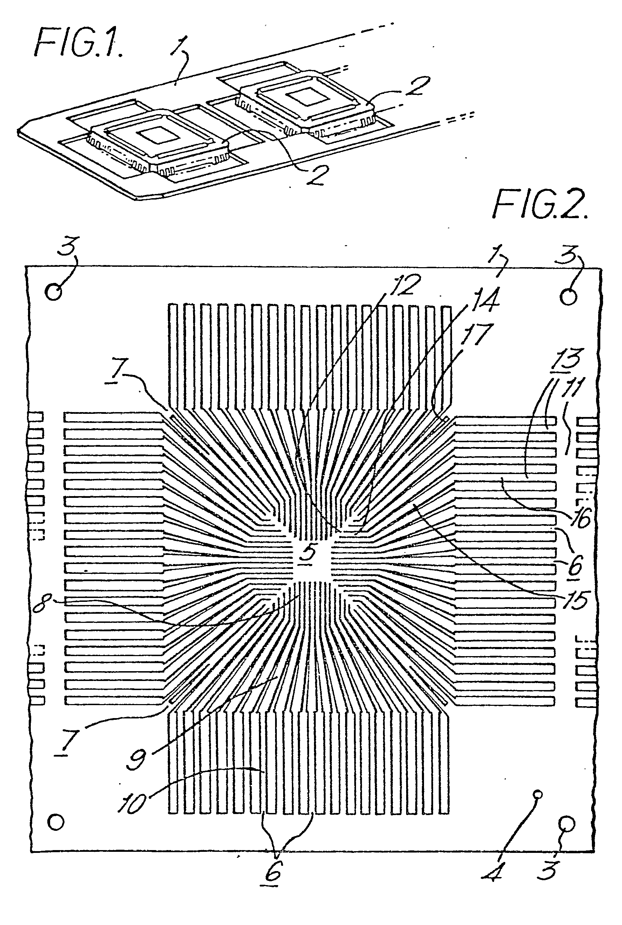

Figure 1 shows a continuous strip comprising a lead frame strip 1 and chip carrier housings 2 moulded on to the lead frame strip 1 in surrounding relationship to each lead frame.

In the description which follows, an individual lead frame of the strip 1, as shown in Figure 2, is first described, and this description is followed by a description of a chip carrier housing 2 and the manner in which a chip can be packaged in the housing 2 and the terminal areas of the chip connected to the leads of the lead frame.

As shown in Figure 2, the lead frame strip 1 comprises a continuous strip of conductive metal provided with pilot holes 3 at regularly spaced intervals adjacent to the side edges, and an index hole 4 adjacent to each lead frame for the purpose of orienting the lead frame during manufacture of a complete assembly.

The lead frame shown in Figure 2 comprises a square central support member 5, and leads 6 and 7 radiating from the support member 5.

The leads 6 are designated simple leads since each comprises a single strip of metal extending from one edge of the support member 5. Each simple lead 6 has an inner end portion 8 which extends normally from one edge of the support member 5, an intermediate portion 9, and an outer end portion 10. The intermediate portions 9 at each side of the support member 5 diverge from each other, and the outer end portions 10 extend parallel to each other. The lead frame of Figure 2 is symmetrical about vertical and horizontal axis, as seen in the drawing. Each lead frame in the strip 1 is separated from adjacent lead frames by a narrow transversely extending portion 11 of the stock metal, as shown in Figure 2.

The leads 7 are designated composite leads, and each comprises a trunk lead 12 which extends from a corner of the central support member 5 at an angle of 45 degrees to the inner end portions 8 of the adjacent simple leads 6. Each composite lead 7 further comprises a plurality of branch leads 13 each of which has an inner end portion 14 which extends from one side edge of the associated trunk lead 12 and parallel to adjacent inner end portions 14 of immediately adjacent simple leads 6. Each branch lead 13 also has an intermediate portion 15 which forms part of an intermediate radiating lead pattern, and an outer end portion 16 which extends parallel to the outer end portions 10 of the simple leads 6. The outer end portions of the composite leads 7 are provided with triangular openings 17 which provide an improved interlock between a chip carrier housing and the lead frame when the housing is moulded on to the lead frame.

The particular lead frame according to the invention, shown in Figure 2, has a total of twenty-eight simple leads 6, seven extending from each of the side edges of the support member 5, and four composite leads 7, each having ten branch leads 13 extending therefrom, five extending from each side edge of each composite lead.

In use of the lead frame of Figure 2, an opening is provided in the centre of the lead frame of a size dependent upon the physical dimensions of the chip to be mounted, and the number of leads required for the chip.

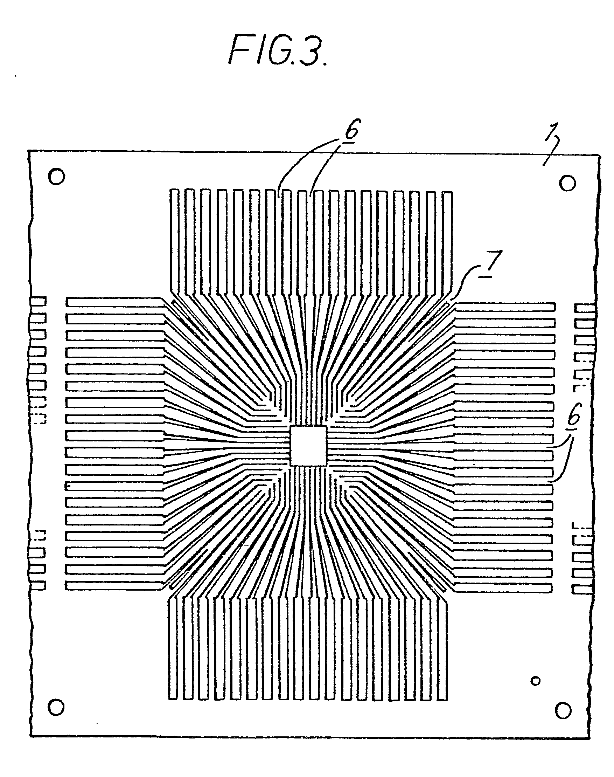

If the lead frame is used in packaging a relatively small chip which requires only twenty-eight leads, the support member 5 only is removed from the lead frame, as shown in Figure 3, and the seven simple leads 6 at each side of this opening are connected to the terminal areas of the chip.

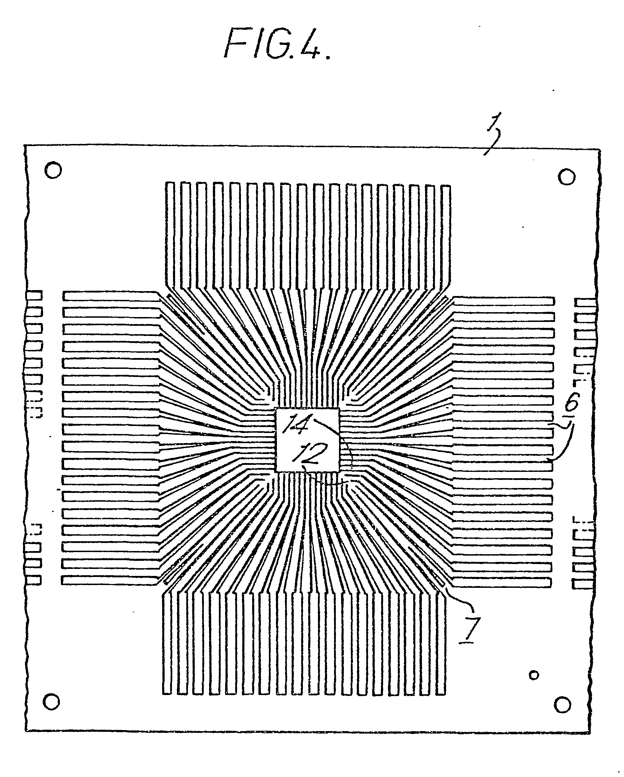

If it is desired to mount a chip of a larger size requiring forty-four leads, an opening as shown in Figure 4 is provided in the centre of the lead frame by removing the centre support member 5, portions of the inner end portions 8 of the simple leads 6, and a portion of each trunk lead 12 adjacent to the support member 5. Upon removal of these inner end portions of the trunk leads 12, some of the branch leads 13 become separated from the trunk lead 12 and can be used to establish electrical connections to the chip.

If a relatively large integrated circuit chip is being mounted, an opening as shown in Figure 5 is provided by removal of the support member 5 and the trunk leads 12 to render all of the branch leads 13 available for establishing connections to the chip so that a total of sixty-eight leads (forty branch leads 13 and twenty-eight simple leads 6) are provided for the chip.

A lead frame as described above can be used with chip carrier housings of many different types and can be used in any desired manufacturing processes for producing chip carrier assemblies. However, there will now be described a specific pre-moulded housing arrangement which permits the accommodation of chips of different sizes.

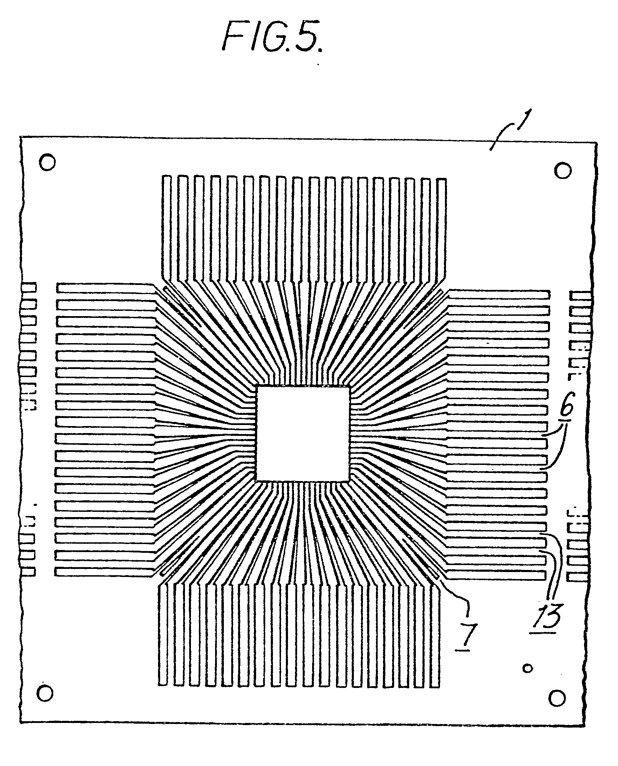

Referring to Figures 6 to 10, housings 18 are moulded on to the strip 1 by a suitable injection moulding apparatus and may be of any suitable thermoplastic material, such as polyphenylene sulfide resin. Suitable filling materials, such as glass fibres, can be used with the resin to provide improved hardness or other desired characteristics in the housings.

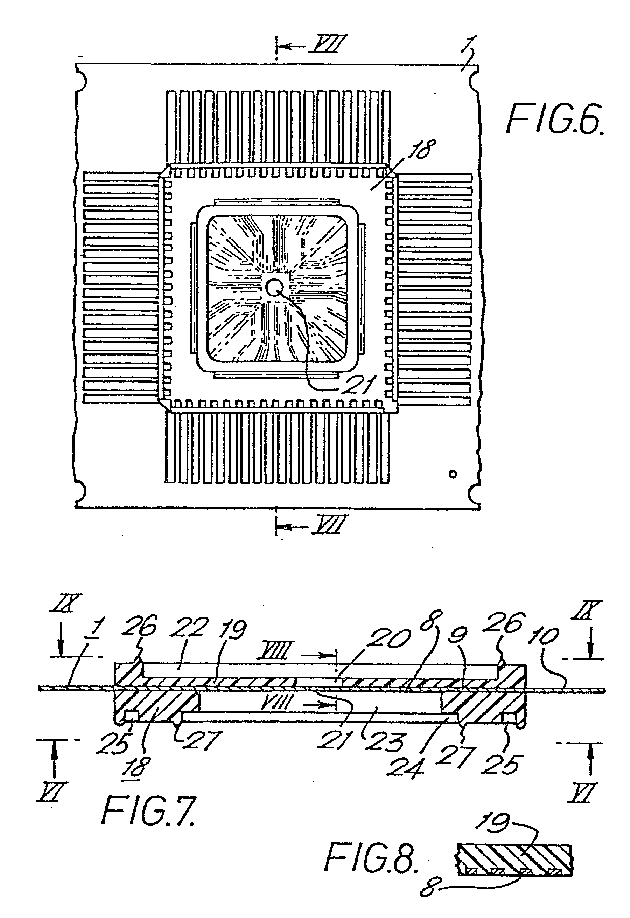

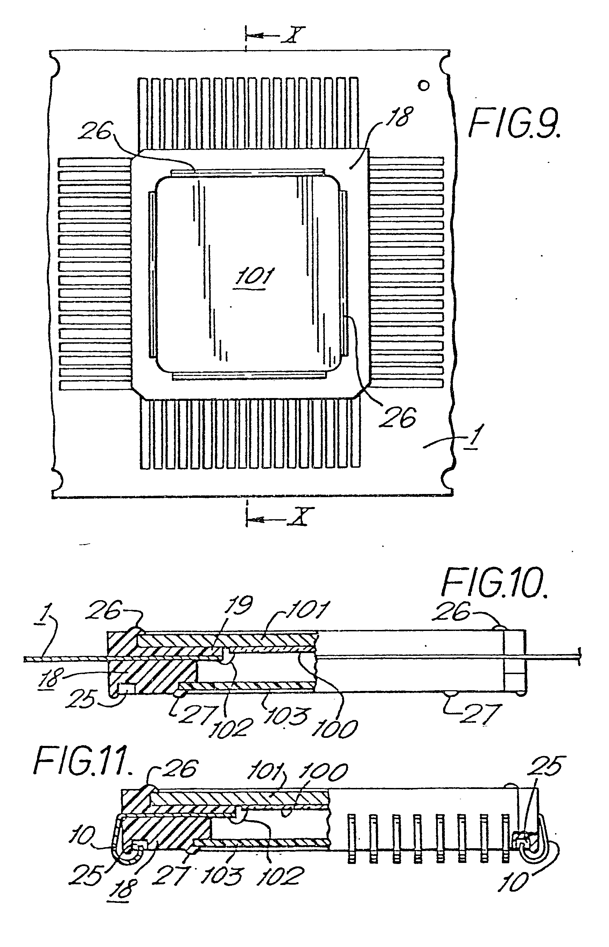

Each housing 18 comprises a square frame-like structure which surrounds the centre of the lead frame and which extends beyond both major surfaces of the strip 1. A relatively thin web 19 extends inwardly from the internal side walls of the housing 18 towards the centre of the lead frame, and an opening 20 is provided in this web 19, which opening 20 is centrally located with respect to the support member 5 of the lead frame. A small central opening 21 is also provided in the support member 5 of the lead frame as shown, the openings 20 and 21 receiving cores used in the moulding process. The inner end portions 8 and 14 of the leads 6 and 13 are embedded in the web 19 but their downwardly facing surfaces are exposed as shown in Figures 8 and 10, and the intermediate portions 9 and 15 of the leads 6 and 13 are totally embedded in the side walls of the housing 18 as clearly shown in Figure 7.

The upper (as seen in the drawings) surface of the housing 18 is formed with a recess 22, while the lower surface has a similar but smaller recess 23 adjacent the strip 1 which recess 23 opens into a slightly larger recess 24. Further recesses 25 are provided in the lower surface around the periphery thereof.

In the manufacture of a chip carrier assembly a portion of the web 19 and the support member 5 of the lead frame are removed by a suitable punch and die to provide an enlarged opening in the web 19, as shown in Figure 10.

A chip 100 (Figure 10) is bonded to a suitable heat sink 101 which is dimensioned to be received in the recess 22, and which is then positioned in the recess 22 as shown in Figure 10. Lips 26 formed around the recess 22 are then thermally reformed, as shown in Figure 10, so that they extend over marginal portions of the heat sink 101 and retain it in the chip carrier housing 18. The terminal areas of the chip are then electrically connected in any suitable way to the ends of the leads, Figure 10 showing conventional wire bond connections 102 extending from the chip 100 to the leads. It will be noted that the chip is positioned immediately adjacent to the leads of the lead frame so that the extremely fine wires 102 are extremely short.

The manufacturing process is completed by filling the central opening of the housing 18 with a suitable material such as a silicone material, mounting a bottom closure member 103 (Figure 10) in the recess 24, and forming lips 27 on the lower surface of the housing over the closure member 103 to retain it in place.

The operations described above can be carried out while the outer end portions 10 and 16 of the leads are integral with the metal strip 1, and after these operations have been carried out, the leads are severed from the metal strip 1 and formed such that their free ends are reversely bent to be received in the recesses 25 in the housing 18, as shown in Figure 11.

Lead frames in accordance with the invention can be used for chips of other than the square configuration shown in the drawings. Square chips are widely used, but chips need not be produced in a square configuration, and a lead frame in accordance with the invention can have simple and composite leads 6, 7 and 13 arranged around a suitably shaped centre support member 5 for chips of any shape.

### Claims

1. A lead frame capable of use with integrated circuit chips of different sizes and having different numbers of terminal areas, characterised in that the lead frame comprises a centrally located support member (5), and a plurality of leads (6, 7) having inner end portions (8, 12) which are integral with the support member (5) and having outer portions (10, 16) forming a radiating pattern relative to the support member (5), at least one (7) of the leads being a composite lead comprising a trunk lead (12) and branch leads (13) extending from side edges of the trunk lead (12) at spaced intervals and at increasing distances from the support member (5), whereby the lead frame can be used with a relatively small chip (100) by removing the support member (5) and connecting the leads (6), excluding the trunk lead (12), the terminal areas of the chip (100), and the lead frame can be used with larger sizes of chips (100) by removing the support member (5) and a portion of the trunk lead (12) adjacent to the support member (5) whereby branch and other leads (13, 6) can be connected to terminal areas of the chip (100).

2. A lead frame as claimed in Claim 1, characterised by a plurality of said composite leads (7) extending from the support member at spaced angular intervals.

3. A lead frame as claimed in Claim 2, characterised in that the support member (5) is rectangular, there being four composite leads (7) extending one from each corner of the support member (5).

4. A lead frame as claimed in any preceding claim, characterised by a plurality of simple leads (6), extending normally from the edges of the support member (5), said branch leads (13) extending parallel to inner end portions (8) of adjacent simple leads (6).

5. In combination, a lead frame as claimed in any preceding claim, and an electrically insulating housing (18) moulded thereon, the housing (18) comprising a frame-like structure moulded on to intermediate portions (9, 15) of the leads (6, 7), inner end portions of the leads extending inwardly from side wall portions of the housing (18), and a web (19) moulded integrally with the frame, the web (19) extending from the side wall portions of the housing (18) substantially to the centre of the lead frame, the inner end portions (8, 13) of the leads (6, 13) being supported by the web (19), whereby an integrated circuit chip (100) having dimensions which lie within a predetermined range can be mounted in the housing (18) by removing a portion of the web (19) and portions of the inner end portions (8, 13) of the leads (6, 7) to form an opening in the web (19) dimensioned to receive the chip (100).

### Revendications

1. Cadre de montage pouvant être utilisé avec des pastilles à circuits intégrés de différentes dimensions et ayant différents nombres de zones de connexion, caractérisé en ce que le cadre de montage comprend un élément de support (5) disposé centralement, et plusieurs conducteurs (6, 7) ayant des tronçons extrêmes intérieurs (8, 12) qui sont solidaires de l'élément (5) de support et ayant des tronçons extérieurs (10, 16) formant une configuration rayonnante par rapport à l'élément (5) de support, au moins un (7) des conducteurs étant un conducteur composé comprenant un tronc conducteur (12) et des branches conductrices (13) s'étendant des bords latéraux du tronc conducteur (12) à intervalles espacés et à des distances croissantes de l'élément (5) de support, de maînère que le cadre de montage puisse être utilisé avec une pastille (100) relativement petite par enlèvement de l'élément (5) de support et connexion des conducteurs (6), à l'exclusion du tronc conducteur (12), sur les zones de connexion de la pastille (100), et que le cadre de montage puisse être utilisé avec de plus grandes dimensions de pastilles (100) par enlèvement de l'élément (5) de support et d'une partie du tronc conducteur (12) adjacente à l'élément (5) de support, afin que des branches et d'autres conducteurs (13, 6) puissent être connectés aux zones de connexion de la pastille (100).

2. Cadre de montage selon la revendication 1, caractérisé par plusieurs desdits conducteurs composés (7) s'étendant de l'élément de support à intervalles angulaires espacés.

3. Cadre de montage selon la revendication 2, caractérisé en ce que l'élément (5) de support est rectangulaire, quatre conducteurs composés (7) s'étendant chacun d'un coin de l'élément (5) de support.

4. Cadre de montage selon l'une quelconque des revendications précédentes, caractérisé par plusieurs conducteurs simples (6) s'étendant normalement des bords de l'élément (5) de support, lesdites branches conductrices (13) s'étendant parallèlement aux tronçons extrêmes intérieurs (8) de conducteurs simples adjacents (6).

5. En combinaison, un cadre de montage selon l'une quelconque des revendications précédentes, et un boîtier électriquement isolant (18) moulé sur ce cadre, le boîtier (18) comprenant une structure analogue à un cadre moulée sur des tronçons intermédiaires (9, 15) des conducteurs (6, 7), des tronçons extrêmes intérieurs des conducteurs s'étendant vers l'intérieur de parties des parois latérales du boîtier (18), et une âme (19) moulée intégralement avec le cadre, l'âme (19) s'étendant des parties de parois latérales du boîtier (18) sensiblement vers le centre du cadre de montage, les tronçons extrêmes intérieurs (8, 13) des conducteurs (6, 13) étant supportés par l'âme (19), de manière qu'une pastille (100) à circuits intégrés, ayant des dimensions comprises dans une plage prédéterminée, puisse être montée dans le boîtier (18) par enlèvement d'une partie de l'âme (19) et de parties des tronçons extrêmes intérieurs (8, 13) des conducteurs (6, 7) pour former dans l'âme (19) une ouverture dimensionnée pour recevoir la pastille (100).

**Patentansprüche**

1. Zuleitungsrahmen, der sich mit integrierten Schaltungs-Chips verwenden läßt, die verschiedene Größen und unterschiedliche Anzahlen von Anschlußflächen aufweisen, dadurch gekennzeichnet, daß der Zuleitungsrahmen ein in der Mitte befindliches Halteelement (5) und eine Mehrzahl von Zuleitungen (6, 7) aufweist, die einstückig mit dem Halteelement (5) ausgebildete innere Endbereiche (8, 12) sowie äußere Bereiche (10, 16), die relativ zu dem Halteelement (5) ein strahlenartig ausgehendes Muster bilden, aufweisen, wobei mindestens eine (7) der Zuleitungen eine zusammengesetzte Zuleitung mit einer Stammzuleitung (12) und Zweigzuleitungen (13) ist, die sich in Abständen und größer werdenden Entfernungen zu dem Halteelement (5) von seitlichen Kanten der Stammzuleitung (12) weg erstrecken, wodurch der Zuleitungsrahmen mit einem relativ kleinen Chip (100) verwendet werden kann, indem das Halteelement (5) entfernt und die Zuleitungen (6), ausgenommen die Stammzuleitung (12), mit den Anschlußflächen des Chips (100) verbunden werden, und wodurch der Zuleitungsrahmen mit Chips (100) größerer Abmessungen verwendet werden kann, indem das Halteelement (5) und ein Teil der Stammzuleitung (12), der sich in der Nähe des Halteelements (5) befindet, entfernt werden, wodurch Zweig- und andere Zuleitungen (13, 6) mit Anschlußflächen des Chips (100) verbunden werden können.

2. Zuleitungsrahmen nach Anspruch 1, gekennzeichnet durch eine Mehrzahl von zusammengesetzten Zuleitungen (7), die sich in Winkelabständen von dem Halteelement weg erstrecken.

3. Zuleitungsrahmen nach Anspruch 2, dadurch gekennzeichnet, daß das Halteelement (5) rechtwinklig ist, wobei vier zusammengesetzte Zuleitungen (7) vorhanden sind, von denen sich eine von jeder Ecke des Halteelements (5) weg erstreckt.

4. Zuleitungsrahmen nach einem der vorausgehenden Ansprüche, gekennzeichnet durch eine Mehrzahl einfacher Zuleitungen (6), die sich rechtwinklig von den Kanten des Halteelements (5) weg erstrecken, wobei sich die Zweigzuleitungen (13) parallel zu inneren Endbereichen (8) benachbarter einfacher Zuleitungen (6) erstrecken.

5. Kombination eines Zuleitungsrahmens nach einem der vorausgehenden Ansprüche und eines daran angegossenen, elektrisch isolierenden Gehäuses (18), wobei das Gehäuse (18) eine rahmenartige Struktur aufweist, die an Zwischenbereiche (9, 15) der Zuleitungen (6, 7) angegossen ist, und wobei sich innere Endbereiche der Zuleitungen von Seitenwandbereichen des Gehäuses (18) nach innen erstrecken, und wobei eine Bahn (19) einstückig mit dem Rahmen gegossen ist und sich von den Seitenwandbereichen des Gehäuses (18) im wesentlichen zum Zentrum des Zuleitungsrahmens erstreckt, und wobei die inneren Endbereiche (8, 13) der Zuleitungen (6, 13) von der Bahn (19) gestützt werden, wodurch ein integrierter Schaltungs-Chip (100), der in einem vorbestimmten Bereich liegende Abmessungen aufweist, dadurch in dem Gehäuse (18) befestigt werden kann, daß ein Teil der Bahn (19) und Teile der inneren Endbereiche (8, 13) der Zuleitungen (6, 7) entfernt werden, um in der Bahn (19) eine Öffnung zu bilden, die für die Aufnahme des Chips (100) dimensioniert ist.

# FIG.1.

# FIG.2.

# FIG.3.

# FIG.4.

# FIG.5.

FIG.6.

FIG.7.

FIG.8.

FIG.9.

FIG.10.

FIG.11.